(19) Europäisches Patentamt / European Patent Office / Office européen des brevets

(11) **EP 1 690 337 B1**

(12) **FASCICULE DE BREVET EUROPEEN**

(45) Date de publication et mention
de la délivrance du brevet:
**27.05.2009 Bulletin 2009/22**

(21) Numéro de dépôt: **04819685.1**

(22) Date de dépôt: **22.11.2004**

(51) Int Cl.:
*H03M 1/36* *(2006.01)*

(86) Numéro de dépôt international:
**PCT/EP2004/053040**

(87) Numéro de publication internationale:
**WO 2005/055431 (16.06.2005 Gazette 2005/24)**

(54) **CONVERTISSEUR ANALOGIQUE-NUMERIQUE RAPIDE**

SCHNELLER ANALOG-DIGITAL-UMSETZER

FAST ANALOGUE-TO-DIGITAL CONVERTER

(84) Etats contractants désignés:
**DE FR GB NL**

(30) Priorité: **02.12.2003 FR 0314134**

(43) Date de publication de la demande:
**16.08.2006 Bulletin 2006/33**

(73) Titulaire: **E2V Semiconductors**
**38120 Saint Egreve (FR)**

(72) Inventeur: **MORISSON, Richard,**
**Thales,**
**Intellectual Property**
**94117 Arcueil (FR)**

(74) Mandataire: **Guérin, Michel et al**
**Marks & Clerk France**
**Conseils en Propriété Industrielle**
**Immeuble " Visium "**
**22, avenue Aristide Briand**
**94117 Arcueil Cedex (FR)**

(56) Documents cités:
**DE-A- 3 807 329**　　　**US-A- 5 396 131**
**US-A- 5 539 406**

**Description**

L'invention concerne les convertisseurs analogiques-numériques rapides à structure parallèle.

Le principe général d'un tel convertisseur est le suivant : un échantillonneur bloqueur fournit une tension analogique stabilisée pendant un bref intervalle de temps qui est le temps nécessaire à la conversion. Un ensemble de comparateurs en parallèle compare cette tension à des tensions de référence définies par un réseau de résistances en série alimentées par un courant constant.

Des structures de comparateurs à entrées différentielles sont utilisées de préférence parce qu'elles éliminent les erreurs dues aux fluctuations de tensions de mode commun. Dans ce cas, on utilise en général la structure suivante : la tension à convertir, sous forme d'une tension différentielle Vin-VinN est appliquée à l'entrée de l'échantillonneur bloqueur E/B qui a une structure différentielle ; les sorties différentielles complémentaires VS et VSN de l'échantillonneur bloqueur, représentant la tension à convertir (VS-VSN est égal à Vi-VinN) sont appliquées sur deux réseaux de N résistances précises, en série ; le courant $I_0$ dans les réseaux est fixé par des sources de courant identiques ; les prises intermédiaires entre les résistances des deux réseaux sont appliquées deux-à-deux aux entrées des N comparateurs de la manière suivante : la résistance de rang i du premier réseau (alimenté par VS) et la résistance de rang N-i du deuxième réseau (alimenté par la tension complémentaire VSN) sont connectées aux entrées du comparateur COMPi de rang i. Les comparateurs basculent dans un sens ou dans un autre selon le niveau de la tension différentielle VS-VSN, et on peut dire en résumé que si la tension VS-VSN correspond à la limite de basculement du comparateur de rang i, tous les comparateurs de rang inférieur à i basculeront dans un sens et tous les comparateurs de rang supérieur à i basculeront dans l'autre sens ; l'état des sorties des comparateurs fournit donc une indication numérique du niveau de tension analogique différentielle d'entrée.

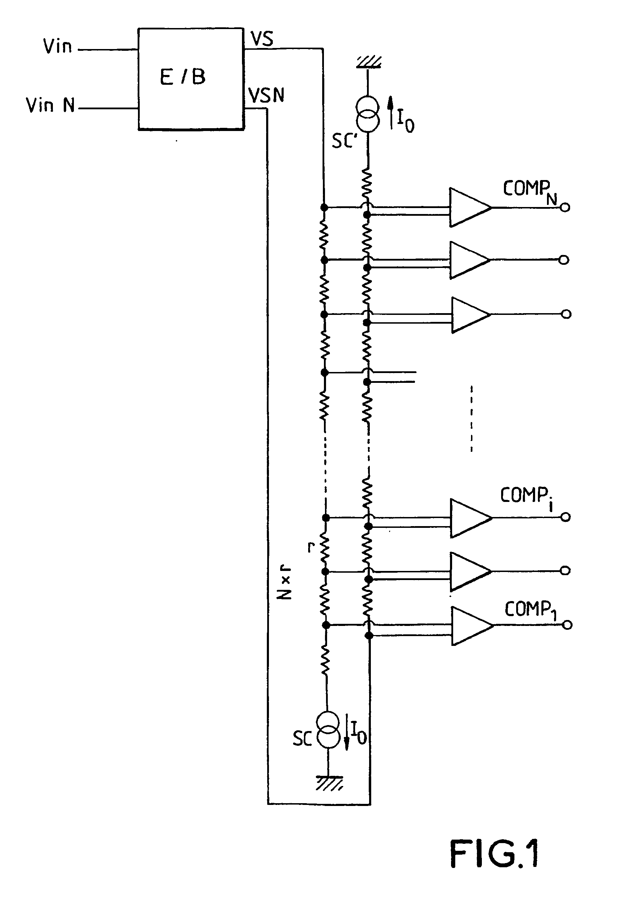

Cette disposition est rappelée sur la figure 1.

Pour des comparateurs rapides, destinés à fournir un signal numérique à une fréquence d'échantillonnage élevée et susceptibles de recevoir une tension d'entrée analogique pouvant varier rapidement, il se pose alors un problème de constante de temps de réaction de la structure qui vient d'être décrite : le réseau de résistances comprend de nombreuses résistances dès lors qu'on veut une haute résolution pour le comparateur. Ces résistances ont-elles même une capacité parasite et elles sont connectées à des comparateurs qui ont aussi des capacités parasites. La combinaison de ces résistances et de ces capacités parasites induit des constantes de temps de transmission entre les sorties de l'échantillonneur bloqueur et les entrées des comparateurs.

Ces constantes de temps ont en particulier l'effet néfaste suivant : puisque les réseaux de résistance sont croisés, le comparateur de rang i reçoit sur une entrée une tension VS-i.r.$I_0$ après un retard qui en gros est lié à la constante de temps introduite par un ensemble de i résistances élémentaires de valeur r en série, alors qu'il reçoit sur une autre entrée la tension VSN-(N-i).r.$I_0$ après un retard qui est lié plutôt à la constante de temps introduite par un ensemble de N-i résistances. On comprend donc que cela ne pose pas de problème particulier quand i et N-i sont presque identiques, mais que cela pose un problème lorsque i est proche de zéro ou de N et N-i proche de N ou zéro : en effet, dans ce cas les constantes de temps sont très différentes, ce qui veut dire que le comparateur concerné va recevoir un niveau de tension plus rapidement sur une entrée que sur l'autre. Dans l'intervalle de temps il peut tout simplement fournir une indication fausse. Il y a donc un risque pour que les comparateurs qui sont à la frontière entre le basculement dans un sens ou dans l'autre fournissent une indication erronée. Cette erreur est d'autant plus sensible si la résolution ou la fréquence de conversion sont plus élevées.

La présente invention a pour but de pallier cet inconvénient dans la mesure du possible.

On propose pour cela un convertisseur analogique-numérique à entrées différentielles et à structure parallèle, comprenant au moins un réseau de N résistances en série de valeur r et un réseau de N comparateurs, dans lequel

- le réseau de résistances en série reçoit une tension de référence (VH) et est parcouru par un courant fixe $I_0$ ;
- le comparateur de rang i (i variant de 1 à N) comprend essentiellement un amplificateur différentiel double à quatre entrées, deux entrées recevant une tension différentielle VS-VSN à convertir, une troisième étant reliée à une résistance de rang i du réseau, et une quatrième entrée étant reliée à une résistance de rang N-i du réseau, l'amplificateur différentiel double fournissant une tension représentant une différence de la forme (VS-VSN) - (N-2i)r.$I_0$, et le comparateur basculant dans un sens ou dans l'autre selon le niveau de la tension VS-VSN et selon le rang i du comparateur lorsque cette différence change de signe.

Le convertisseur est **caractérisé en ce que** le réseau de résistances est alimenté par une tension de référence variable issue d'un circuit d'asservissement qui asservit le niveau de tension du milieu du réseau de résistances à une tension égale à la tension de mode commun (VS+VSN)/2 de la tension différentielle à convertir

Le brevet US 5 396 131 décrit une structure de convertisseur dans laquelle le réseau de résistances est alimenté par une tension de référence fixe.

L'amplificateur différentiel double à quatre entrées est en pratique constitué par deux amplificateurs différentiels simples qui ont leurs sorties reliées en parallèle, chacun d'eux recevant une des deux tensions différentielles d'entrée d'une part et une des deux tensions issues du réseau de résistances d'autre part.

Dans une réalisation avantageuse, le réseau de résistances est alimenté par une tension de référence variable issue d'un circuit d'asservissement qui asservit le niveau de tension du milieu du réseau de résistances à une tension égale à la tension de mode commun (VS-VSN)/2 présente sur la sortie de l'échantillonneur bloqueur. Cette tension égale à la tension de mode commun est de préférence prélevée en sortie d'un amplificateur tampon dont les caractéristiques de courant et de tension reproduisent les caractéristiques d'un amplificateur différentiel qui fournit les tensions analogiques à convertir VS et VSN. Cet amplificateur tampon reproduit donc en principe les caractéristiques de mode commun de l'amplificateur de sortie de l'échantillonneur bloqueur qui fournit le signal analogique à convertir.

Dans une autre réalisation avantageuse, le circuit d'asservissement fournit une tension de référence variable au réseau de résistances et à un autre réseau de résistances semblable au premier, l'asservissement étant effectué à partir d'une tension prélevée au milieu de l'autre réseau de résistances.

D'autres caractéristiques et avantages de l'invention apparaîtront à la lecture de la description détaillée qui suit et qui est faite en référence aux dessins annexés dans lesquels :

- la figure 1, déjà décrite, représente la structure d'un convertisseur analogique-numérique différentiel rapide de l'art antérieur ;
- la figure 2 représente la structure d'un convertisseur selon l'invention ;
- la figure 3 représente le schéma d'un comparateur élémentaire utilisé dans le schéma de la figure 2 ;
- la figure 4 représente une variante de réalisation dans laquelle une tension prélevée sur un point milieu du réseau de résistances sert à l'asservissement de la tension appliquée à ce réseau ;
- la figure 5 représente une cellule de référence constituée de manière à fournir une tension de référence égale à la tension de mode commun de l'échantillonneur bloqueur ;
- la figure 6 représente une autre variante de réalisation dans laquelle la tension servant à l'asservissement est prélevée sur un réseau miroir du premier réseau de résistances.

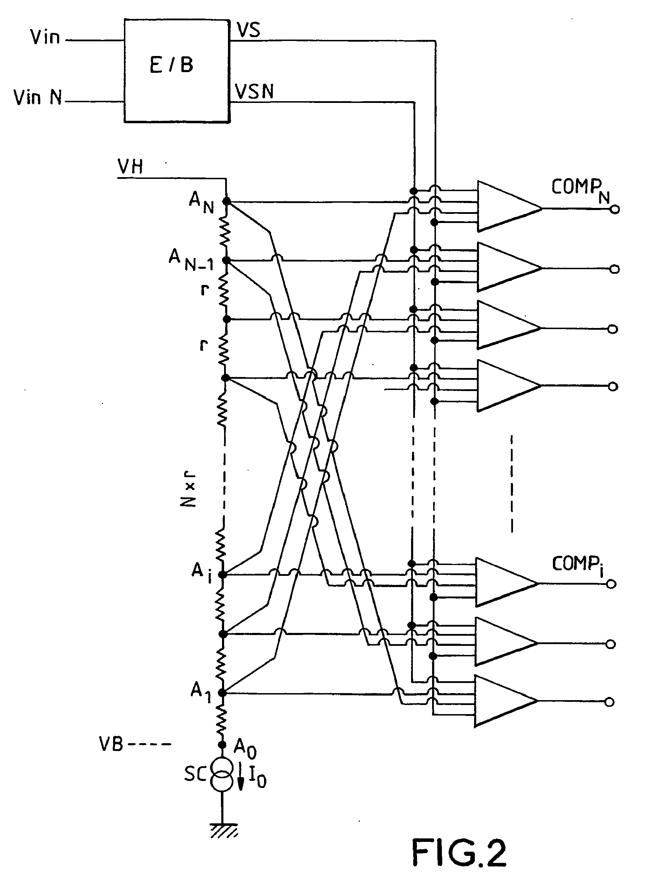

La figure 2 représente la structure générale du convertisseur selon l'invention. La sortie de l'échantillonneur bloqueur est une sortie différentielle fournissant une tension VS et une tension complémentaire VSN, stables pendant la durée de la conversion de l'échantillon courant.

Un réseau de N résistances identiques de valeur r en série, est alimenté en courant constant de valeur $I_0$ à partir d'une tension haute VH ; une source de courant SC en série avec le réseau définit la valeur du courant

constant $I_0$. Si on appelle i le rang d'une résistance de valeur r dans l'ensemble en série, i variant de 1 à N-1, $A_i$ est le noeud reliant la résistance de rang i et la résistance de rang i+1 ; $A_0$ est le noeud reliant la source de courant SC à la résistance de rang 1 ; VH est le potentiel du noeud $A_N$.

On peut calculer le potentiel en tout noeud du réseau de résistances à partir de VH, r et $I_0$.

Le potentiel du noeud $A_i$ est VH-(N-i).r.$I_0$. Le potentiel du noeud $A_{N-i}$ est VH-i.r.$I_0$.

Un réseau de N comparateurs doubles $COMP_i$ de rang i =1 à N reçoit d'une part les tensions présentes sur les noeuds du réseau de résistances et d'autre part la tension VS et la tension VSN. Plus précisément, le comparateur double de rang i reçoit sur un premier groupe d'entrées d'une part la tension VS et d'autre part la tension présente sur le noeud $A_{N-i}$ de rang N-i, et il reçoit sur un deuxième groupe d'entrées d'une part la tension complémentaire VSN et d'autre part la tension présente sur le noeud $A_i$ de rang i.

Par comparateur double, on entend ici essentiellement un amplificateur différentiel double dont les sorties sont reliées entre elles de manière croisée comme on l'expliquera plus loin ; l'amplificateur différentiel double comprend simplement deux amplificateurs différentiels simples, le premier amplificateur recevant VS et le noeud $A_{N-i}$, le deuxième recevant VSN et le noeud $A_i$. Les sorties des amplificateurs sont réunies pour agir en sommateur ; en croisant les sorties on fait une différence, de sorte que les sorties fournissent une tension différentielle représentant, avec un coefficient correspondant au gain de l'amplificateur, la différence des différences de tension appliquées aux entrées prises deux à deux :

$$VS-(VH-i.r.I_0) \text{ et } VSN-\{VH-(N-i).r.I_0\}$$

La sortie différentielle de l'amplificateur double représente alors :

$$VS-VSN - (N-2i).r.I_0$$

Cette sortie, éventuellement réamplifiée par un amplificateur à grand gain, permet de convertir en un niveau logique le signe de la différence VS-VSN - (N-2i).r.$I_0$

Tous les comparateurs pour lesquels VS-VSN est supérieur à (N-2i).r.$I_0$ basculent dans un sens, tous les comparateurs pour lesquels VS-VSN est inférieur à (N-2i).r.$I_0$ basculent dans l'autre sens.

La valeur numérique convertie est déterminée par le rang du comparateur tel que tous les comparateurs au-dessous de ce rang soient dans un premier état et tous les comparateurs au-dessus de ce rang soient dans un second état.

Le nombre de résistances r donne la résolution du comparateur. L'ajustement du courant $I_0$ permet d'ajuster la plage de conversion, c'est-à-dire la valeur maximale de VS-VSN qui peut être convertie avec la précision définie par le nombre de résistances r.

Pour minimiser les effets dus aux tensions de mode commun et à leurs fluctuations, on s'arrange pour que la tension au milieu du réseau de résistances, c'est-à-dire en pratique la tension présente sur le noeud $A_{N/2}$, soit égale à la tension de mode commun des sorties de l'échantillonneur bloqueur :

$$VH -.r.I_0.N/2 = (VS+VSN)/2$$

On règle donc VH en conséquence et on verra plus loin qu'on peut la régler à partir d'un asservissement.

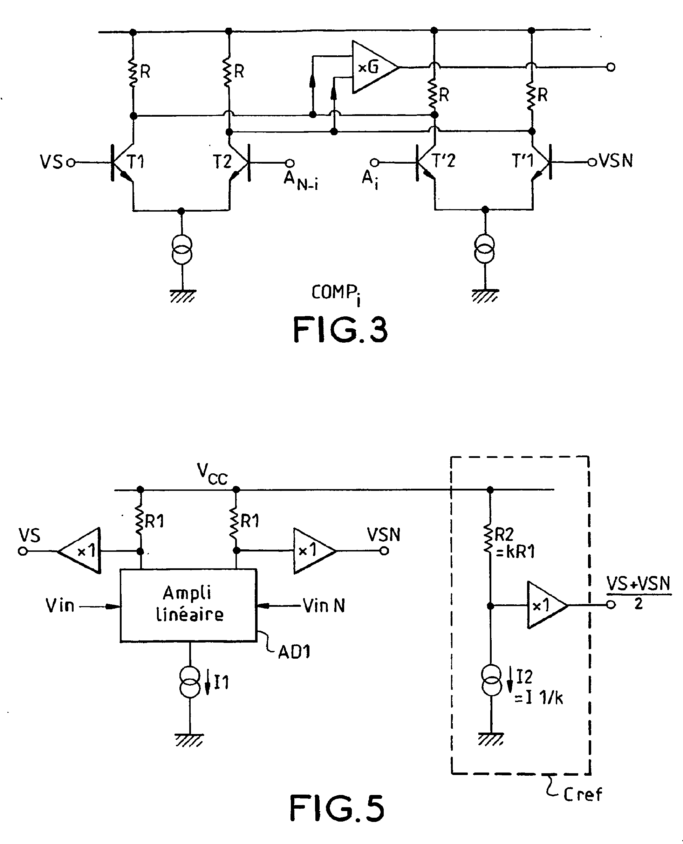

La figure 3 représente la constitution détaillée d'un amplificateur différentiel double à sorties réunies croisées utilisé dans les comparateurs $COMP_i$ de la figure 2. Les transistors représentés sont des transistors bipolaires mais ils peuvent être aussi MOS.

Il comprend deux amplificateurs différentiels linéaires simples à grand gain, identiques et constitués d'une manière classique, c'est-à-dire avec deux branches symétriques alimentées par le courant d'une seule source de courant constant, chaque branche comprenant un transistor en série avec une résistance de charge R. Les bases des transistors sont les entrées des amplificateurs. Le premier amplificateur reçoit VS sur la base du premier transistor T1 et le noeud $A_{N-i}$ sur la base du deuxième transistor T2. Le deuxième amplificateur reçoit VSN sur la base du premier transistor T'1 et le noeud $A_i$ sur la base du deuxième transistor T'2. Les sorties sont montées en sommateur mais croisées : la sortie constituée par le collecteur de T1 est reliée à la sortie constituée par le collecteur de T'2 pour constituer une première sortie de l'amplificateur différentiel double, et réciproquement les collecteurs de T'1 et T2 sont reliés pour constituer une deuxième sortie de l'amplificateur différentiel double ; la sortie du comparateur est constituée par l'une de ces sorties, par exemple le collecteur de T1 et T'2, ou bien par une sortie d'un amplificateur à grand gain dont les entrées reçoivent les sorties de l'amplificateur double.

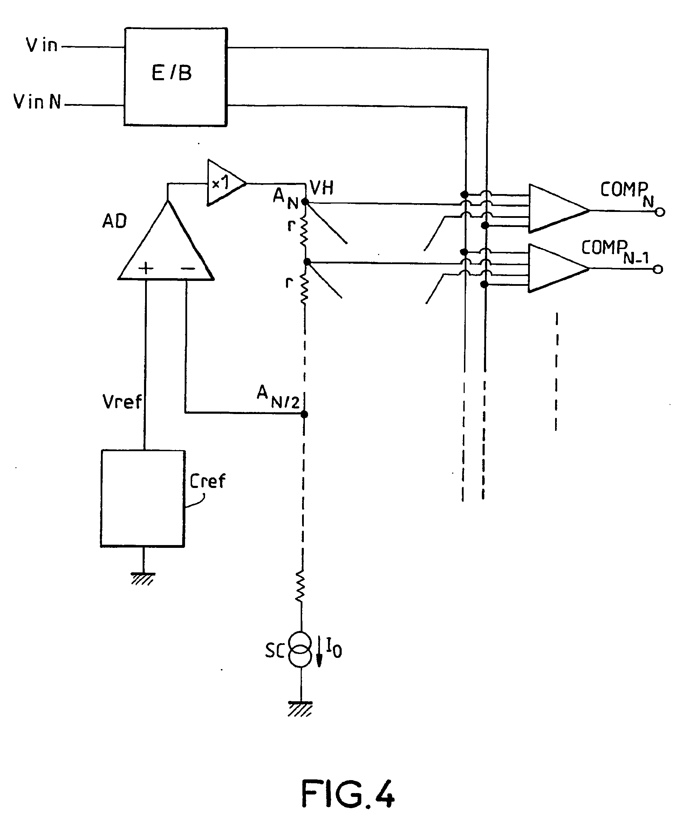

La figure 4 représente une variante de réalisation du convertisseur, dans laquelle la tension VH est déterminée automatiquement par un circuit asservi sur la tension de mode commun de l'échantillonneur bloqueur E/B.

On utilise un amplificateur différentiel AD à grand gain, ayant une première entrée reliée au noeud $A_{N/2}$ représentant le milieu du réseau de résistances et une deuxième entrée reliée à la sortie d'une cellule Cref de détermination de la tension de mode commun. La sortie de l'amplificateur différentiel fournit la tension VH, soit directement, soit par l'intermédiaire d'un amplificateur tampon de gain unitaire et de grande impédance d'entrée et de faible impédance de sortie ; une résistance peut également être intercalée entre la sortie de l'amplificateur tampon et la borne $A_N$.

La tension VH sur la borne $A_N$ s'asservit automatiquement de manière que la différence de tensions à l'entrée de l'amplificateur soit pratiquement nulle. La tension VH prend donc une valeur telle que la tension du noeud $A_{N/2}$ soit égale à la tension de sortie de la cellule de référence.

La cellule Cref doit fournir une tension égale à la tension de mode commun (VS+VSN)/2 qui existe en sortie de l'échantillonneur bloqueur. Pour cela, la cellule comprend simplement un étage amplificateur tampon constitué avec des éléments géométriquement semblables à ceux de l'étage de sortie de l'échantillonneur bloqueur.

La figure 5 représente la constitution de l'étage de sortie de l'échantillonneur bloqueur et la cellule de référence. L'étage de sortie de l'échantillonneur peut être symbolisé à partir d'un amplificateur linéaire différentiel AD1 chargé par deux résistances R1 et alimenté par une source de courant commune de valeur I1. Des amplificateurs tampons de gain unitaire sont reliés aux sorties différentielles de l'amplificateur ; ces amplificateurs tampons fournissent les tensions VS et VSN. La cellule de référence, alimentée par la même tension Vcc que l'échantillonneur bloqueur, utilise tout simplement un ensemble en série d'une résistance R2 et d'une source de courant de valeur 12, et un amplificateur tampon de gain unitaire identique à ceux qui définissent les sorties de l'échantillonneur bloqueur. La résistance R2 est égale à k fois (k arbitraire, plus grand que 1 pour limiter la consommation) la résistance de charge R1 des étages de sortie de l'échantillonneur bloqueur ; la source de courant 12 est égale à 1/k fois la source de courant I1 de l'étage différentiel qui constitue l'étage de sortie différentiel de l'échantillonneur bloqueur.

Cette cellule fournit une tension Vref qui est égale à la tension de mode commun (VS+VSN)/2 de l'échantillonneur bloqueur.

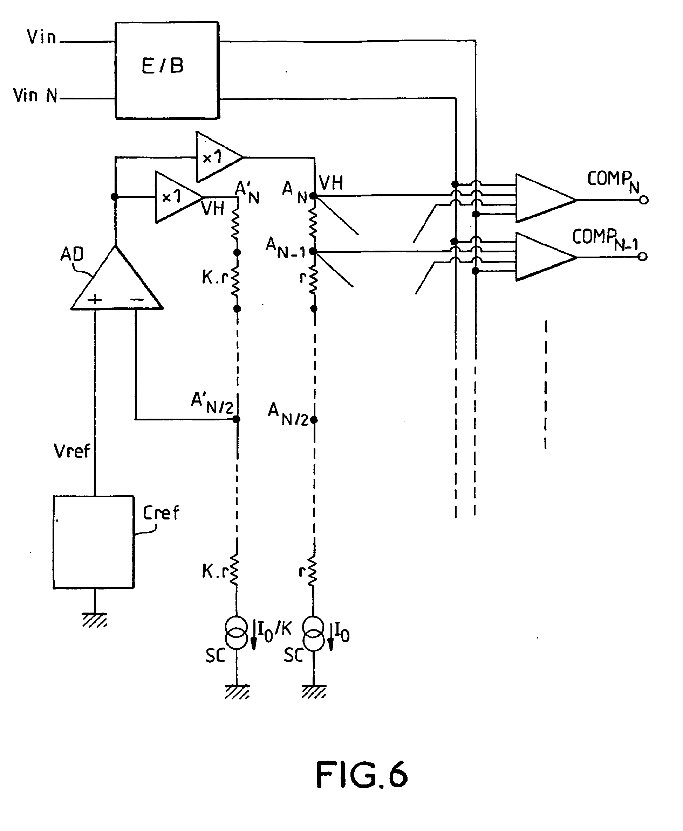

La figure 6 représente une autre variante de réalisation du convertisseur, dans laquelle l'asservissement de la tension d'alimentation VH du réseau de résistances est réalisé à partir d'un deuxième réseau de résistances, semblable au premier. Ce deuxième réseau est de préférence constitué de résistances de valeur K.r et est parcouru par un courant $I_0/k$ pour consommer moins de courant. La tension appliquée à l'extrémité du deuxième réseau (noeud $A'_N$ du deuxième réseau) est la même tension VH que celle qui est appliquée au noeud $A_N$ du premier réseau. Elle est appliquée par un amplificateur tampon identique à celui qui applique la tension VH au premier réseau, à partir de la sortie de l'amplificateur différentiel AD qui contrôle l'asservissement. Cet amplificateur différentiel, au lieu de recevoir le point milieu $A_{N/2}$ du premier réseau, reçoit le point milieu $A_{N/2}$ du deuxième réseau. Les tensions sur tous les noeuds du deuxième réseau sont identiques à celles sur les noeuds correspondants du premier réseau, par conséquent l'asservissement à partir du noeud $A'_{N/2}$ est identique à un asservissement à partir du noeud $A_{N/2}$.

L'avantage de cette disposition est qu'on évite de perturber l'asservissement par des variations de niveaux de tension qui pourraient apparaître sur le noeud $A_{N/2}$ par influence capacitive ou influence du substrat semiconducteur lors de variations importantes de la tension à convertir.

On a ainsi décrit un convertisseur analogique-numérique à réseau de résistances qui évite l'influence négative des constantes de temps dues aux capacités et résistances du réseau comme c'était le cas dans le schéma de la figure 1. En effet, le réseau de résistances ne reçoit plus la tension à convertir mais une tension fixe (à part les fluctuations de niveau de mode commun qui interviennent seulement de manière secondaire).

Le convertisseur selon l'invention reste cependant un convertisseur différentiel, ce qui présente des avantages notamment pour l'élimination des distorsions dues aux harmoniques pairs des tensions à convertir.

Enfin, étant donné que les capacités parasites du réseau de résistances n'interviennent plus au premier ordre, on peut prévoir que le réseau de résistances est réalisé par des résistances de plus grande dimension dans le circuit intégré, ce qui permet de les réaliser avec une meilleure précision. Typiquement, alors qu'on s'obligeait à réaliser des résistances de l'ordre de 1 à 2 micromètres de largeur pour minimiser leurs capacités parasites, on peut passer par exemple à des résistances de l'ordre de 200 à 600 micromètres de large.

## Revendications

1. Convertisseur analogique-numérique à entrées différentielles et à structure parallèle, comprenant au moins un réseau de N résistances en série de valeur r et un réseau de N comparateurs, dans lequel

    - le réseau de résistances en série reçoit une tension de référence (VH) et est parcouru par un courant fixe $I_0$ ;
    - le comparateur (COMP$_i$) de rang i, i variant de 1 à N, comprend essentiellement un amplificateur différentiel double à quatre entrées, deux entrées recevant une tension différentielle VS-VSN à convertir, une troisième entrée étant reliée à une résistance de rang i du réseau, et une quatrième entrée étant reliée à une résistance de rang N-i du réseau, l'amplificateur différentiel double fournissant une tension représentant une différence de la forme (VS-VSN) - (N-2i)r.$I_0$, et le comparateur basculant dans un sens ou dans l'autre selon le niveau de la tension VS-VSN et selon le rang i du comparateur lorsque cette différence change de signe,

**caractérisé en ce que** la tension de référence reçu par le réseau de résistances est une tension de référence variable (VH) issue d'un circuit d'asservissement (Cref, AD) qui asservit le niveau de tension du milieu du réseau de résistances à une tension égale à la tension de mode commun (VS+VSN)/2 de la tension différentielle à convertir.

2. Convertisseur selon la revendication 1, **caractérisé en ce que** le circuit d'asservissement fournit la tension de référence variable au réseau de résistances et à un autre réseau de résistances semblable au premier, l'asservissement étant effectué à partir d'une tension prélevée au milieu de l'autre réseau de résistances.

3. Convertisseur selon l'une des revendications 1 et 2, **caractérisé en ce que** l'amplificateur différentiel double à quatre entrées est constitué par deux amplificateurs différentiels simples qui ont leurs sorties reliées en parallèle, chacun d'eux recevant une des deux tensions différentielles d'entrée d'une part et une des deux tensions issues du réseau de résistances d'autre part.

## Claims

1. Analogue-to-digital converter having differential inputs and a parallel structure, comprising at least one network of N series resistors with value r and one network of N comparators, in which

    - the series resistor network receives a reference voltage (VH) and is traversed by a fixed current $I_0$;
    - the row i, i varying from 1 to N, comparator (COMP$_i$) essentially comprises a dual differential amplifier with four inputs, two inputs receiving a differential voltage VS-VSN to be converted, a third input being connected to a row i resistor of the network, and a fourth input being connected to an N-i row resistor of the network, the dual differential amplifier supplying a voltage representing a difference of the form (VS-VSN) - (N-2i)r.$I_0$, and the comparator switching in one direction or the other depending on the level of the voltage VS-VSN and on the row i of the comparator when said difference changes sign,

**characterized in that** reference voltage received by the resistor network is a variable reference voltage (VH) originating from a servoloop circuit (Cref, DA) which locks the voltage level of the middle of the resistor network at a voltage equal to the common mode voltage (VS-VSN)/2 of the differential voltage to be converted.

**2.** Converter according to Claim 1, **characterized in that** the servoloop circuit supplies the variable reference voltage to the resistor network and to another resistor network similar to the first, locking being performed starting from a voltage taken from the middle of the other resistor network.

**3.** Converter according to either of Claims 1 and 2, **characterized in that** the dual differential amplifier with four inputs is composed of two single differential amplifiers, the outputs of which are connected in parallel, each of them receiving, on the one hand, one of the two input differential voltages and, on the other hand, one of the two voltages originating from the resistor network.

**Patentansprüche**

**1.** Analog-Digital-Umsetzer mit Differenzialeingängen und paralleler Struktur, der mindestens ein Netzwerk aus N Widerständen in Serie mit Wert r und ein Netzwerk aus N Komparatoren aufweist, bei dem

- das Widerständenetzwerk in Serie eine Referenzspannung (VH) empfängt und von einem gleich bleibenden Strom $I_0$ durchlaufen wird;
- ein Komparator ($COMP_i$) mit Rang i, wobei i von 1 bis N variiert, im Wesentlichen einen doppelten Differenzialverstärker mit vier Eingängen aufweist, wobei zwei Eingänge eine Differenzspannung VS-VSN, die umzusetzen ist, empfangen, wobei ein dritter Eingang mit einem Widerstand mit Rang i des Netzwerks verbunden ist, und wobei ein vierter Eingang mit einem Widerstand mit Rang N-i des Netzwerks verbunden ist, wobei der doppelte Differenzialverstärker eine Spannung liefert, die einen Unterschied der Form (VS-VSN) - (N-2i)r.$I_0$ aufweist, und wobei der Komparator je nach dem Niveau der Spannung VS-VSN und gemäß dem Rang i des Komparators in die eine Richtung oder die andere kippt, wenn dieser Unterschied das Vorzeichen wechselt,

**dadurch gekennzeichnet, dass** die von dem Widerständenetzwerk empfangene Referenzspannung eine variable Referenzspannung (VH) ist, die aus einem Regelkreis (Cref, AD) stammt, der das Spannungsniveau der Mitte des Widerständenetzwerks auf eine Spannung gleich der Common-Mode-Spannung (VS+VSN)/2 der umzusetzenden Differenzspannung regelt.

**2.** Umsetzer nach Anspruch 1, **dadurch gekennzeichnet, dass** der Regelkreis die variable Referenzspannung an das Widerständenetzwerk und an ein anderes, dem ersten ähnliches Widerständenetzwerk liefert, wobei die Regelung ausgehend von einer Spannung ausgeführt wird, die aus der Mitte des anderen Widerständenetzwerks entnommen wird.

**3.** Umsetzer nach einem der Ansprüche 1 und 2, **dadurch gekennzeichnet, dass** der doppelte Differenzialverstärker mit vier Eingängen aus zwei einfachen Differenzialverstärkern besteht, deren Ausgänge parallel geschaltet sind, wobei jeder jeweils eine der zwei Eingangsdifferenzspannungen einerseits und eine der zwei Spannungen, die aus dem Widerständenetzwerk stammen, andererseits empfängt.

FIG.1

FIG.2

COMP$_i$

## FIG.3

## FIG.5

FIG.4

FIG.6

**RÉFÉRENCES CITÉES DANS LA DESCRIPTION**

**Documents brevets cités dans la description**

- US 5396131 A